# EUROPEAN PATENT SPECIFICATION

(11) **EP 3 349 422 B1**
(45) Date of publication and mention of the grant of the patent: **16.10.2019**
(21) Application number: 17857654.2
(22) Date of filing: 13.11.2017
(51) Int. Cl.: H04M 1/02, G06F 1/16

(54) **FOLDING COMPONENT AND MOBILE TERMINAL**
KLAPPBARES BAUTEIL UND MOBILES ENDGERÄT
ÉLÉMENT PLIABLE ET TERMINAL MOBILE

(30) Priority: 17.11.2016 CN 201611022449
(43) Date of publication of application: 18.07.2018
(73) Proprietor: HUAWEI TECHNOLOGIES CO., LTD., Guangdong 518129 (CN)
(72) Inventor: WU, Wenwen, Shenzhen Guangdong 518129 (CN); ZHONG, Ding, Shenzhen Guangdong 518129 (CN); FAN, Wen, Shenzhen Guangdong 518129 (CN)
(74) Representative: Gill Jennings & Every LLP
(86) International application number: PCT/CN2017/110710
(87) International publication number: WO 2018/090888

(56) References cited:
- EP-A1- 2 728 434
- WO-A1-2015/191411
- CN-A- 102 262 845
- CN-A- 105 549 689
- US-A1- 2014 126 133
- US-A1- 2015 257 289
- US-B1- 9 173 288

## Description

### TECHNICAL FIELD

This application relates to the field of mobile terminal technologies, and in particular, to a foldable component and a mobile terminal.

### BACKGROUND

Because a large-screen mobile phone has an obvious advantage over a small-screen mobile phone in visual and entertainment experience. Currently, there is a trend that a majority of flagship mobile phone products of mainstream manufacturers are designed with large screens. However, compared with a small-screen mobile phone, a large-screen mobile phone has great disadvantages in holding comfortability and portability. As flexible display panels are gradually put into commercial use, foldable mobile phones become a main direction of development of next-generation mobile phones by mainstream device manufacturers, thanks to their characteristics of flexible and variable sizes of display panels in different usage scenarios. However, in a folding or unfolding process, a flexible display panel is easily damaged due to bending or squeezing, and a service life of a mobile phone is greatly shortened.

CN 105549689 A discloses a folding terminal. US 9173288 B1 discloses a foldable display apparatus which can maintain a bending part of an unfolder flexible display in a plane state. WO 2015/191411 A1 discloses a computing device that have hinged portions.

### SUMMARY

To resolve the foregoing technical problems, embodiments of this application provide a foldable component, where the foldable component is configured to bear a flexible display panel and protect the flexible display panel from damage in a folding or unfolding process.

In accordance with an aspect of the invention, there is provided a foldable component for a mobile terminal according to appended claim 1. Preferable features of the invention are defined in the appended dependent claims.

To achieve the foregoing objectives, the following technical solutions are used in implementations of this application:
According to a first aspect, an embodiment of this application provides a foldable component for a mobile terminal, configured to bear a flexible display panel and including:
a first support component, providing a first sliding slot;
a second support component, providing a second sliding slot;
a bending support component, connected between the first support component and the second support component, where the bending support component includes a first end and a second end that are opposite to each other, the first end extends into the first sliding slot, and the second end extends into the second sliding slot; and
a support layer, configured to bear the flexible display panel, where the support layer is attached to the first support component, the bending support component, and the second support component, the bending support component is configured to allow the first end to slide in the first sliding slot and the second end to slide in the second sliding slot in a folding or unfolding process of the bending support component, the first support component, the bending support component, and the second support component are configured to drive folding or unfolding of the support layer, no relative offset exists between the first support component and the support layer, no relative offset exists between the second support component and the support layer, and no relative offset exists between the support layer and a fitting surface between the bending support component and the support layer;
wherein the bending support component includes a first sliding block, a hinge, and a second sliding block that are connected in sequence, the first sliding block cooperates with the first sliding slot, the second sliding block cooperates with the second sliding slot, the first end is formed at an end of the first sliding block far away from the hinge, and the second end is formed at an end of the second sliding block far away from the hinge;
wherein the hinge includes a first chain segment, at least one intermediate chain segment, and a second chain segment that are connected in sequence by means of tooth meshing, a fixed connection exists between the first chain segment and the first sliding block, and a fixed connection exists between the second chain segment and the second sliding block;
wherein the foldable component further includes a limiting block, the limiting block is located between the first support component and the second support component, the at least one intermediate chain segment is rotationally connected to the limiting block, and the limiting block includes a first limiting rod and a second limiting rod that are disposed opposite to each other; and
a first limiting slot is provided on the first support component, a second limiting slot is provided on the second support component, the first limiting rod cooperates with the first limiting slot, the second limiting rod cooperates with the second limiting slot, and in a process in which the first support component is folded or unfolded relative to the second support component, the first support component moves relative to the first limiting rod along an extension track of the first limiting slot, and the second support component moves relative to the second limiting rod along an extension track of the second limiting slot.

In this implementation, in the folding or unfolding process of the bending support component, the first end slides in the first sliding slot, and the second end slides in the second sliding slot. Therefore, the bending support component can flexibly shrink or extend relative to the support layer. For example, if the bending support component is located on an internal side of the support layer, the bending support component shrinks when folded, and the bending support component extends when unfolded, so that a size of the support layer remains unchanged; or if the bending support component is located on an external side of the support layer, the bending support component extends when folded, and the bending support component shrinks when unfolded, so that a size of the support layer remains unchanged. Because the size of the support layer is always unchanged, a size of the flexible display panel fitted onto the support layer is also unchanged, no relative offset exists between the first support component and the support layer, no relative offset exists between the second support component and the support layer, and no relative offset exists between the support layer and the fitting surface between the bending support component and the support layer. Therefore, damage caused by pulling or squeezing the flexible display panel can be avoided. In other words, the foldable component can protect the flexible display panel from damage in the folding or unfolding process.

In this implementation, the limiting block is configured to avoid over-travel of the bending support component in the folding or unfolding process.

It may be understood that because the first chain segment, the at least one intermediate chain segment, and the second chain segment are connected in sequence by means of tooth meshing, moving tracks of these chain segments are determined. The foldable component moves along a fixed track in the folding or unfolding process. Therefore, a probability of damage caused to the flexible display panel can be further reduced. Likewise, in relative moving of the first chain segment, the at least one intermediate chain segment, and the second chain segment, the tooth meshing connection structure also makes moving actions relatively smooth. Therefore, folding and unfolding actions of the bending support component are also relatively smooth, a deformation process of the support layer is smooth and gentle, and the probability of damage caused to the flexible display panel can be further reduced.

The first chain segment and the first sliding block may be an integrated structure, or a fixed connection may be implemented by using a pin or by welding. The second chain segment and the second sliding block may be an integrated structure, or a fixed connection may be implemented by using a pin or by welding.

The support layer uses an elastic material that is not easily subject to tensile deformation, for example, an elastic metal sheet, so that the support layer always keeps a smooth surface in the deformation process. This further reduces the probability of damage caused to the flexible display panel.

In an implementation, after the hinge is folded, an arc external profile is formed, and the arc external profile is used to support the support layer. In this case, the support layer is located on an external side of the bending support component, the support layer attached to the external profile is smooth and has no obvious bulge, and the flexible display panel is located on the external side of the support layer. When the mobile terminal is folded, the flexible display panel is located on an external side of the mobile terminal, and is in a visible state.

In an implementation, sidewalls of the first limiting slot and the second limiting slot both have an arc surface, so that a moving action of the stop component is smooth and gentle. This helps reduce the probability of damage caused to the flexible display panel.

In an implementation, the foldable component further includes a first fixing block and a second fixing block, the first fixing block is mounted on the first support component, the second fixing block is mounted on the second support component, a third sliding slot is provided on one side of the first fixing block, and a fourth sliding slot is provided on one side of the second fixing block; and
the foldable component further includes a third sliding block, a second hinge, and a fourth sliding block that are connected in sequence, the third sliding block extends into the third sliding slot, a moving direction of the third sliding block in the third sliding slot is consistent with a moving direction of the first sliding block in the first sliding slot, the fourth sliding block extends into the fourth sliding slot, a moving direction of the fourth sliding block in the fourth sliding slot is consistent with a moving direction of the second sliding block in the second sliding slot, the second hinge is disposed side by side with the hinge to jointly support the support layer and keeps a same moving track as the hinge, and the limiting block is mounted on the second hinge and configured to limit a moving position of the second hinge.

In an implementation, the second hinge is connected to one end of the hinge and rotates synchronously with the hinge. For example, a shaft slot is provided in a chain segment of the hinge, a pin shaft is provided in a chain segment of the second hinge, and the pin shaft is inserted in the shaft slot and used to fix the hinge and the second hinge.

In an implementation, after the hinge is folded, an arc internal profile is formed, and the arc internal profile is used to support the support layer. In this case, the support layer is located on an internal side of the bending support component, the support layer attached to the internal profile is smooth and has no obvious bulge, and the flexible display panel is located on the internal side of the support layer. When the mobile terminal is folded, the flexible display panel is located on an internal side of the mobile terminal, and is in an invisible state.

In an implementation, the support layer is a continuous elastic metal sheet, so that the support layer and the hinge support each other. This further reduces the probability of damage caused to the flexible display panel. The elastic metal sheet includes an extremely thin steel sheet.

In an implementation, the foldable component further includes a limiting hinge, the limiting hinge forms a first sliding portion, a connecting portion, and a second sliding portion that are connected in sequence, the hinge of the bending support component is rotationally connected to the connecting portion, the first sliding portion includes a first group of limiting rods, and the second sliding portion includes a second group of limiting rods; and
a first group of limiting slots is provided on the first support component, a second group of limiting slots is provided on the second support component, the first group of limiting rods cooperates with the first group of limiting slots, the second group of limiting rods cooperates with the second group of limiting slots, and the limiting hinge is configured to limit a moving position of the hinge.

In an implementation, the limiting hinge includes a plurality of limiting chain segments, the adjacent limiting chain segments are connected by means of tooth meshing, each limiting chain segment includes two central shafts, the first group of limiting rods includes a first rod and a second rod, a central line of the first rod and a central line of the second rod are respectively connected to and collinear in the two central shafts, the first group of limiting slots includes a first slot and a second slot, extension directions of the first slot and the second slot are different, so that a moving track of the limiting hinge in the folding or unfolding process of the foldable component is determined, the first rod cooperates with the first slot, and the second rod cooperates with the second slot.

In an implementation, an extension direction of the first slot or the second slot is parallel to a surface of the first support component connected to the support layer, so that a travel range of the limiting chain segments is shortened.

According to a second aspect, an embodiment of this application further provides a mobile terminal, including the foldable component according to any one of the foregoing and a flexible display panel, where the flexible display panel is attached to the support layer, the flexible display panel forms a first display area, a second display area, and a third display area that are connected in sequence, the first display area faces the first support component, the second display area faces the bending support component, and the third display area faces the second support component.

The flexible display panel also has display and touch functions.

### BRIEF DESCRIPTION OF DRAWINGS

To describe the technical solutions in this application more clearly, the following briefly describes the accompanying drawings required for describing the implementations. Apparently, the accompanying drawings in the following description show merely some implementations of this application, and a person of ordinary skill in the art may still derive other drawings from these accompanying drawings without creative efforts.
FIG. 1 is a schematic structural view of a mobile terminal unfolded according to an embodiment of this application;
FIG. 2 is a schematic structural view of a mobile terminal folded according to an embodiment of this application;
FIG. 3 is a sectional structural view of an A-A part in FIG. 1;
FIG. 4 is a sectional structural view of a C-C part in FIG. 2;
FIG. 5 is a schematic structural view of a bending support component of a mobile terminal according to an embodiment of this application;
FIG. 6 is a schematic structural view of a stop component of a mobile terminal according to an embodiment of this application;
FIG. 7 is a sectional structural view of a B-B part in FIG. 1;
FIG. 8 is a sectional structural view of a D-D part in FIG. 2;
FIG. 9 is a schematic structural view of another stop component of a mobile terminal according to an embodiment of this application;
FIG. 10 is a schematic structural view of another mobile terminal unfolded according to an embodiment of this application;
FIG. 11 is a schematic structural view of another mobile terminal folded according to an embodiment of this application;
FIG. 12 is an exploded view of a stop component of another mobile terminal according to an embodiment of this application;
FIG. 13 is a sectional structural view of an E-E part in FIG. 10; and
FIG. 14 is a sectional structural view of an F-F part in FIG. 11.

### DESCRIPTION OF EMBODIMENTS

The following describes the embodiments of this application with reference to accompanying drawings.

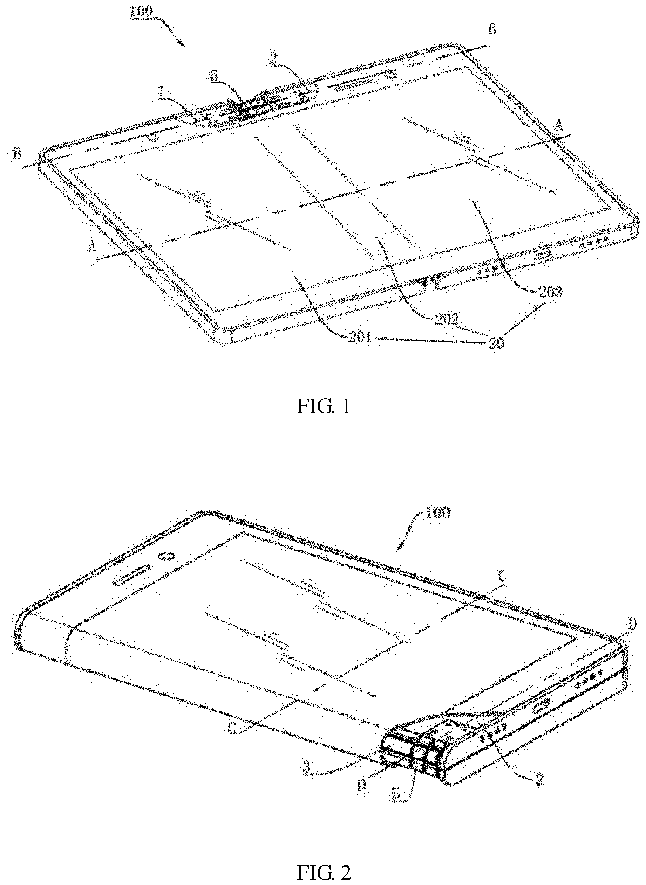

Referring to FIG. 1 to FIG. 4, a mobile terminal 100 provided by an embodiment of this application includes a foldable component 10. The foldable component 10 is configured to bear a flexible display panel 20, so that a size of the flexible display panel 20 remains unchanged in an entire bending process of folding or unfolding, and that the flexible display panel 20 is free from being pulled or squeezed.

The foldable component 10 includes a first support component 1, a second support component 2, a bending support component 3, and a support layer 4. A first sliding slot 11 is provided on one side of the first support component 1. A second sliding slot 21 is provided on one side of the second support component 2. The bending support component 3 is flexibly connected between the first support component 1 and the second support component 2. The bending support component 3 includes a first end 31 and a second end 32 that are opposite to each other. The first end 31 extends into the first sliding slot 11, and the second end 32 extends into the second sliding slot 21. The support layer 4 is configured to bear the flexible display panel 20. One side of the support layer 4 is attached to surfaces of the first support component 1, the bending support component 3, and the second support component 2, and the other side is used to fit the flexible display panel 20. In a process in which the first support component 1 is folded or unfolded relative to the second support component 2, the bending support component 3 is folded or unfolded, the first end 31 slides in the first sliding slot 11, the second end 32 slides in the second sliding slot 21, the first support component 1, the bending support component 3, and the second support component 2 drive folding or unfolding of the support layer 4, no relative offset exists between the first support component 1 and the support layer 4, no relative offset exists between the second support component 2 and the support layer 4, and no relative offset exists between the support layer 4 and a fitting surface between the bending support component 3 and the support layer 4.

In this embodiment, in a folding or unfolding process of the bending support component 3, the first end 31 slides in the first sliding slot 11, and the second end 32 slides in the second sliding slot 21. Therefore, the bending support component 3 can flexibly shrink or extend relative to the support layer 4. For example, if the bending support component 3 is located on an internal side of the support layer 4, the bending support component 3 shrinks when folded, and the bending support component 3 extends when unfolded, so that a size of the support layer 4 remains unchanged; or if the bending support component 3 is located on an external side of the support layer 4, the bending support component 3 extends when folded, and the bending support component 3 shrinks when unfolded, so that a size of the support layer 4 remains unchanged. Because the size of the support layer 4 is always unchanged, the size of the flexible display panel 20 fitted onto the support layer 4 is also unchanged, no relative offset exists between the first support component 1 and the support layer 4, no relative offset exists between the second support component 2 and the support layer 4, and no relative offset exists between the support layer 4 and the fitting surface between the bending support component 3 and the support layer 4. Therefore, damage caused by pulling or squeezing the flexible display panel 20 can be avoided. In other words, the foldable component 10 can protect the flexible display panel 20 from damage in the folding or unfolding process.

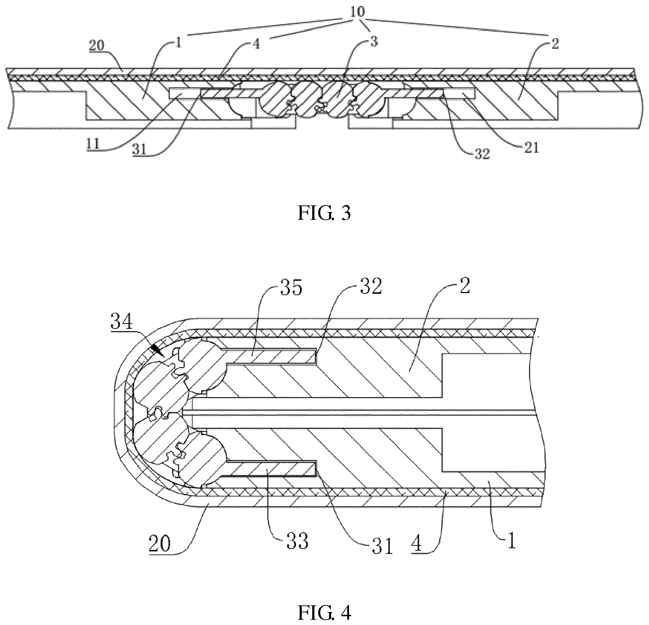

Further, referring to FIG. 3 to FIG. 5, in an optional embodiment, the bending support component 3 includes a first sliding block 33, a hinge 34, and a second sliding block 35 that are connected in sequence. The first sliding block 33 cooperates with the first sliding slot 11, and the second sliding block 34 cooperates with the second sliding slot 21. The first end 31 is formed at an end of the first sliding block 33 far away from the hinge 34, and the second end 32 is formed at an end of the second sliding block 35 far away from the hinge 34.

The hinge 34 includes a first chain segment 341, at least one intermediate chain segment 342, and a second chain segment 343 that are connected in sequence by means of tooth meshing. A fixed connection exists between the first chain segment 341 and the first sliding block 33, and a fixed connection exists between the second chain segment 343 and the second sliding block 35. It may be understood that because the first chain segment 341, the at least one intermediate chain segment 342, and the second chain segment 343 are connected in sequence by means of tooth meshing, moving tracks of these chain segments are determined. The foldable component 10 moves along a fixed track in the folding or unfolding process. Therefore, a probability of damage caused to the flexible display panel 20 can be further reduced. Likewise, in relative moving of the first chain segment 341, the at least one intermediate chain segment 342, and the second chain segment 343, the tooth meshing connection structure also makes moving actions relatively smooth. Therefore, folding and unfolding actions of the bending support component 3 are also relatively smooth, a deformation process of the support layer 4 is smooth and gentle, and the probability of damage caused to the flexible display panel 20 can be further reduced.

The first chain segment 341 and the first sliding block 33 may be an integrated structure, or a fixed connection may be implemented by using a pin or by welding. The second chain segment 343 and the second sliding block 35 may be an integrated structure, or a fixed connection may be implemented by using a pin or by welding.

The support layer 4 uses an elastic material that is not easily subject to tensile deformation, for example, an elastic metal sheet, so that the support layer 4 always keeps a smooth surface in the deformation process. This further reduces the probability of damage caused to the flexible display panel 20. The elastic metal sheet includes but is not limited to an extremely thin steel sheet.

Referring to FIG. 3 to FIG. 5, in an optional embodiment, after the hinge 34 is folded (that is, the bending support component 3 is folded), an arc external profile is formed, and the arc external profile is used to support the support layer 4. In this case, the support layer 4 is located on an external side of the bending support component 3, the support layer 4 attached to the external profile is smooth and has no obvious bulge, and the flexible display panel 20 is located on the external side of the support layer 4. When the mobile terminal 100 is folded, the flexible display panel 20 is located on an external side of the mobile terminal, and is in a visible state.

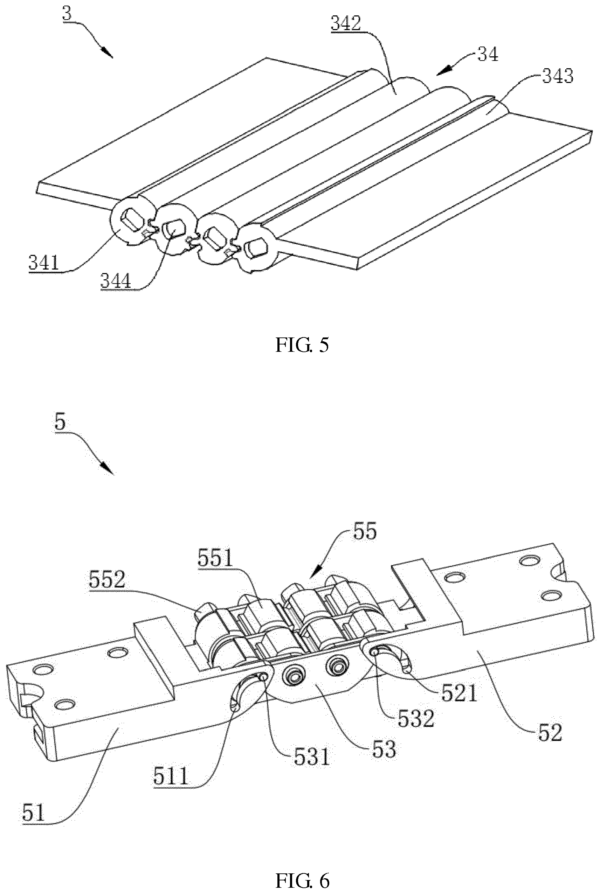

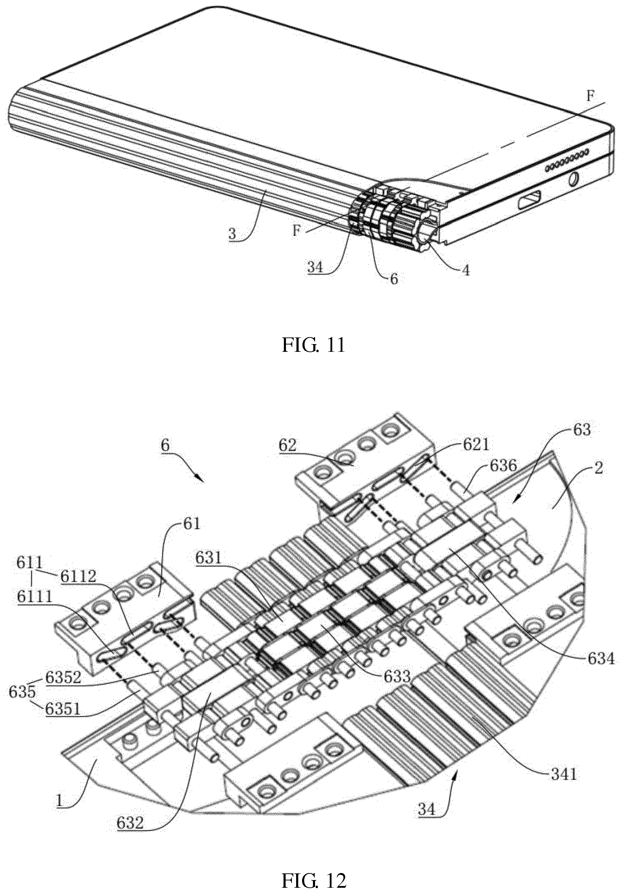

Each of the first chain segment 341, the at least one intermediate chain segment 342, and the second chain segment 343 has one or two central shafts. For example, the hinge 34 may use a chain segment that has only one central shaft (the central shaft may be provided in a shaft slot 344) as shown in FIG. 5, or may use a chain segment that has two central shafts as shown in FIG. 12. A design of a moving track of the hinge 34 using a chain segment that has two central shafts is more flexible and changeable.

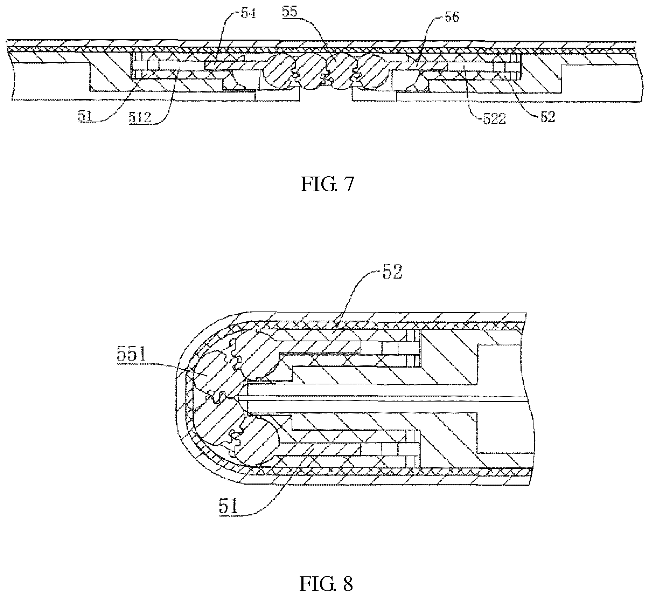

Referring to FIG. 1 to FIG. 8, the foldable component 10 further includes a stop component 5. The stop component 5 is connected to the first support component 1, the bending support component 3, and the second support component 2, and configured to avoid over-travel of the bending support component 3 in the folding or unfolding process. Details are described hereinafter.

The stop component 5 includes a limiting block 53. The limiting block 53 is located between the first support component 1 and the second support component 2. The at least one intermediate chain segment 342 is rotationally connected to the limiting block 53. The limiting block 53 includes a first limiting rod 531 and a second limiting rod 532 that are disposed opposite to each other.

A first limiting slot 511 is provided on the first support component 1, and a second limiting slot 521 is provided on the second support component 2. The first limiting rod 531 cooperates with the first limiting slot 511, and the second limiting rod 532 cooperates with the second limiting slot 521. In the process in which the first support component 1 is folded or unfolded relative to the second support component 2, the first support component 1 moves relative to the first limiting rod 531 along an extension track of the first limiting slot 511, and the second support component 2 moves relative to the second limiting rod 532 along an extension track of the second limiting slot 521. The stop component 5 can limit a moving position of the hinge 34 by using the limiting block 53.

Sidewalls of the first limiting slot 511 and the second limiting slot 521 both have an arc surface, so that a moving action of the stop component 5 is smooth and gentle. This helps reduce the probability of damage caused to the flexible display panel 20.

In an optional embodiment, the stop component 5 may further include a first fixing block 51 and a second fixing block 52. The first fixing block 51 is mounted on the first support component 1, and the second fixing block 52 is mounted on the second support component 2. A third sliding slot 512 is provided on one side of the first fixing block 51, and a fourth sliding slot 522 is provided on one side of the second fixing block 52.

The stop component 5 further includes a third sliding block 54, a second hinge 55, and a fourth sliding block 56 that are connected in sequence. The third sliding block 54 extends into the third sliding slot 512, and a moving direction of the third sliding block 54 in the third sliding slot 512 is consistent with a moving direction of the first sliding block 33 in the first sliding slot 11. The fourth sliding block 56 extends into the fourth sliding slot 522, and a moving direction of the fourth sliding block 56 in the fourth sliding slot 522 is consistent with a moving direction of the second sliding block 35 in the second sliding slot 21. The second hinge 55 is disposed side by side with the hinge 34 to jointly support the support layer 4 and keeps a same moving track as the hinge 34. The limiting block 53 is mounted on the second hinge 55 and configured to limit a moving position of the second hinge 55.

In an optional embodiment, the second hinge 55 is connected to one end of the hinge 34 and rotates synchronously with the hinge 34.

In an optional embodiment, the first limiting slot 511 may be directly provided on the first support component 1, or the first limiting slot 511 may be provided on the first fixing block 51 and then the first fixing block 51 is mounted on the first support component 1. The second limiting slot 521 may be directly provided on the second support component 2, or the second limiting slot 521 may be provided on the second fixing block 52 and then the second fixing block 52 is mounted on the second support component 2.

In an optional embodiment, the first limiting slot 511 and the second limiting slot 521 are provided symmetrically. The first limiting slot 511 includes a near end point close to a center of the limiting block 53 and a far end point far away from the center of the limiting block 53. The second limiting slot 521 includes a near end point close to the center of the limiting block 53 and a far end point far away from the center of the limiting block 53. When the bending support component 3 is completely unfolded, the first limiting rod 531 is located at the near end point of the first limiting slot 511, and the second limiting rod 532 is located at the near end point of the second limiting slot 521. In the folding process of the bending support component 3, the first limiting rod 531 moves from the near end point to the far end point of the first limiting slot 511, and the second limiting rod 532 moves from the near end point to the far end point of the second limiting slot 521. When the bending support component 3 is completely folded, the first limiting rod 531 is located at the far end point of the first limiting slot 511, and the second limiting rod 532 is located at the far end point of the second limiting slot 521. In the unfolding process of the bending support component 3, the first limiting rod 531 moves from the far end point to the near end point of the first limiting slot 511, and the second limiting rod 532 moves from the far end point to the near end point of the second limiting slot 521.

It may be understood that setting positions of the near end point and the far end point of the first limiting slot 511 and positions of the near end point and the far end point of the second limiting slot 521 can limit a maximum-folding position and a maximum-unfolding position of the bending support component 3, and avoid over-travel of the bending support component 3 in the folding or unfolding process.

When the bending support component 3 is in the maximum-unfolding position, a part of the support layer 4 attached to the first support component 1 and a part thereof attached to the second support component 2 are coplanar; or when the bending support component 3 is in the maximum-folding position, a part of the support layer 4 attached to the first support component 1 and a part thereof attached to the second support component 2 are parallel and not coplanar.

Referring to FIG. 6 to FIG. 8, the second hinge 55 includes four chain segments 551 that are connected in sequence, and a pin shaft 552 is provided in each chain segment 551. The pin shaft 552 is inserted in the shaft slot 344 and used to fix the hinge 34 and the second hinge 55. Connections between adjacent chain segments 551 are implemented by means of tooth meshing. Two intermediate chain segments 551 are rotationally connected to the limiting block 53. Specifically, the limiting block 53 is connected to the chain segment 551 by a rotating shaft. The rotating shaft may be fixed at one end of the chain segment 551 and protrude. A shaft hole is provided in the limiting block 53. The rotating shaft cooperates with the shaft hole, so that the chain segment 551 is rotationally connected to the limiting block 53. Among the four chain segments 551, two chain segments 551 located on two sides are fixedly connected to the third sliding block 54 and the fourth sliding block 56 respectively.

Because of the cooperation between the first limiting rod 531 and the first limiting slot 511, the cooperation between the second limiting rod 532 and the second limiting slot 521, the cooperation between the third sliding block 54 and the third sliding slot 512, the cooperation between the fourth sliding block 56 and the fourth sliding slot 522, and tooth meshing connection relationships between the adjacent chain segments 551, a moving track of each chain segment 551 of the second hinge 55 is determined. Because the hinge 34 keeps the same moving track as the second hinge 55, the track of the hinge 34 is also fixed, and the bending support component 3 moves along the fixed track in the folding or unfolding process. This can further reduce the probability of damage caused to the flexible display panel 20.

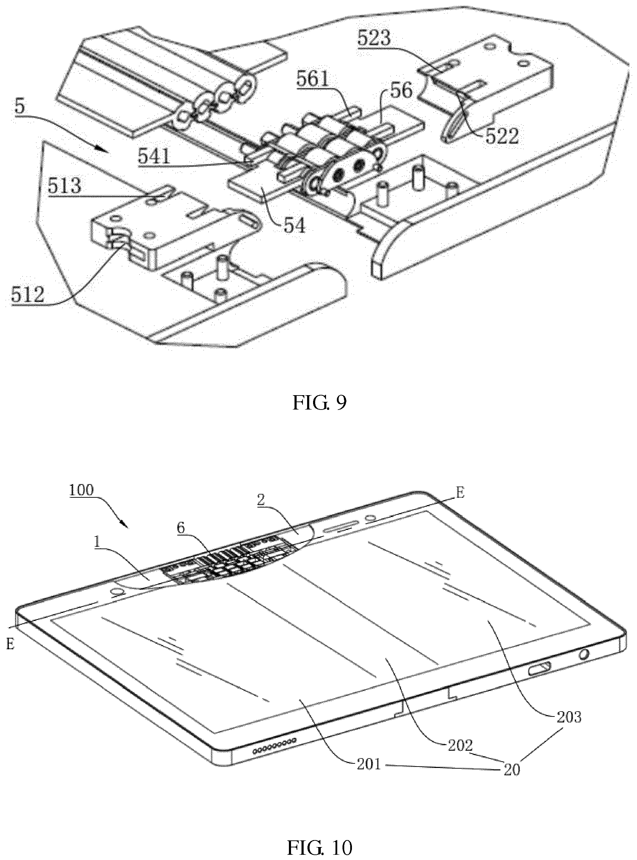

As shown in FIG. 9, a guiding block 541 is provided on the third sliding block 54, a guiding slot 513 is formed on the third sliding slot 512, and the guiding block 541 cooperates with the guiding slot 513, so that the third sliding block 54 moves along a predetermined track.

As shown in FIG. 9, a guiding block 561 is provided on the fourth sliding block 56, a guiding slot 523 is formed on the fourth sliding slot 522, and the guiding block 561 cooperates with the guiding slot 523, so that the fourth sliding block 56 moves along a predetermined track.

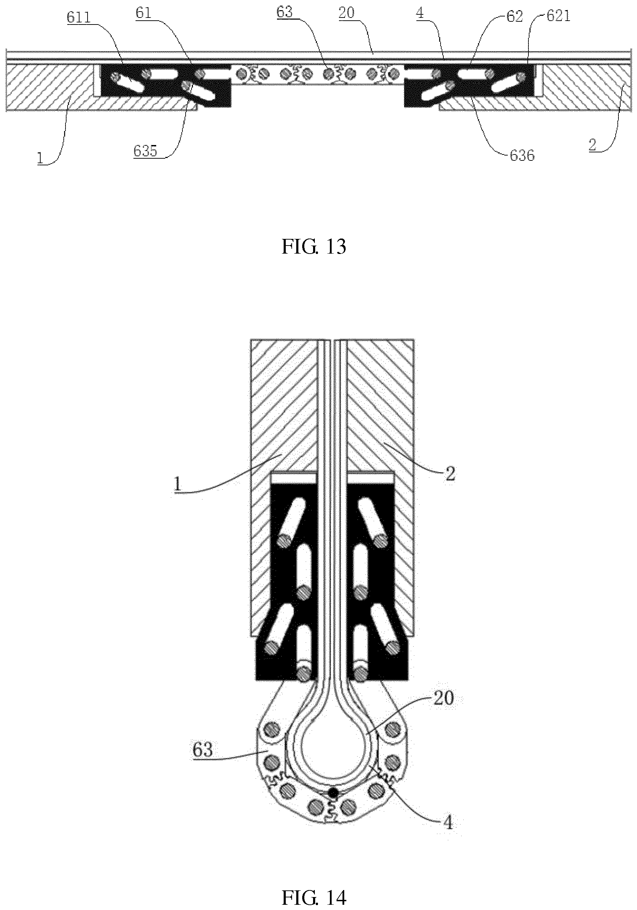

Referring to FIG. 10 to FIG. 14, in an optional embodiment, after the hinge 34 is folded (that is, the bending support component 3 is folded), an arc internal profile is formed, and the arc internal profile is used to support the support layer 4. In this case, the support layer 4 is located on an internal side of the bending support component 3, the support layer 4 attached to the internal profile is smooth and has no obvious bulge, and the flexible display panel 20 is located on the internal side of the support layer 4. When the mobile terminal 100 is folded, the flexible display panel 20 is located on an internal side of the mobile terminal, and is in an invisible state.

Each of the first chain segment 341, the at least one intermediate chain segment 342, and the second chain segment 343 has two central shafts. The first chain segment 341, the at least one intermediate chain segment 342, and the second chain segment 343 are in long strip shapes. The two central shafts are respectively disposed at two ends. When the hinge 34 is folded, the hinge 34 is approximately in a ring shape, and has an arc internal profile, so that the support layer 4 attached to the internal profile is smooth and has no obvious bulge. The support layer 4 uses an elastic material that is not easily subject to tensile deformation, for example, a continuous elastic metal sheet, so that the support layer 4 and the hinge 34 support each other. This further reduces the probability of damage caused to the flexible display panel 20. The elastic metal sheet includes but is not limited to an extremely thin steel sheet.

The foldable component 10 further includes a stop component 6. The stop component 6 is connected to the first support component 1, the bending support component 3, and the second support component 2, and configured to avoid over-travel of the bending support component 3 in the unfolding process.

For example, the stop component 6 includes a limiting hinge 63. The limiting hinge 63 forms a first sliding portion 632, a connecting portion 633, and a second sliding portion 634 that are connected in sequence. The hinge 34 of the bending support component 3 is rotationally connected to the connecting portion 633. The first sliding portion 632 includes a first group of limiting rods 635. The second sliding portion 634 includes a second group of limiting rods 636. A first group of limiting slots 611 is provided on the first support component 1. A second group of limiting slots 621 is provided on the second support component 2. The first group of limiting rods 635 cooperates with the first group of limiting slots 611. The second group of limiting rods 636 cooperates with the second group of limiting slots 621. The limiting hinge 63 is configured to limit a moving position of the hinge 34.

Each slot in the first group of limiting slots 611 includes a near end point close to a center of the limiting hinge 63 and a far end point far away from the center of the limiting hinge 63. Each slot in the second group of limiting slots 621 includes a near end point close to the center of the limiting hinge 63 and a far end point far away from the center of the limiting hinge 63. When the bending support component 3 is completely unfolded, the plurality of limiting rods in the first group of limiting rods 635 are located at the far end points of the plurality of slots in the first group of limiting slots 611 correspondingly on a one-to-basis, and the plurality of limiting rods in the second group of limiting rods 636 are located at the far end points of the plurality of slots in the second group of limiting slots 621 correspondingly on a one-to-basis. In the folding process of the bending support component 3, the plurality of limiting rods in the first group of limiting rods 635 move from the far end points to the near end points of the plurality of slots in the first group of limiting slots 611, and the plurality of limiting rods in the second group of limiting rods 636 move from the far end points to the near end points of the plurality of slots in the second group of limiting slots 621. When the bending support component 3 is completely folded, the plurality of limiting rods in the first group of limiting rods 635 are located at the near end points of the plurality of slots in the first group of limiting slots 611 correspondingly on a one-to-basis, and the plurality of limiting rods in the second group of limiting rods 636 are located at the near end points of the plurality of slots in the second group of limiting slots 621 correspondingly on a one-to-basis. In the unfolding process of the bending support component 3, the plurality of limiting rods in the first group of limiting rods 635 move from the near end points to the far end points of the plurality of slots in the first group of limiting slots 611, and the plurality of limiting rods in the second group of limiting rods 636 move from the near end points to the far end points of the plurality of slots in the second group of limiting slots 621.

It may be understood that setting positions of the near end points and the far end points of the plurality of slots in the first group of limiting slots 611 and positions of the near end points and the far end points of the plurality of slots in the second group of limiting slots 621 can limit a maximum-folding position and a maximum-unfolding position of the bending support component 3, and avoid over-travel of the bending support component 3 in the folding or unfolding process.

When the bending support component 3 is in the maximum-unfolding position, a part of the support layer 4 attached to the first support component 1 and a part thereof attached to the second support component 2 are coplanar; or when the bending support component 3 is in the maximum-folding position, a part of the support layer 4 attached to the first support component 1 and a part thereof attached to the second support component 2 are parallel and not coplanar.

In an optional embodiment, the stop component 6 further includes a third fixing block 61 and a fourth fixing block 62. The third fixing block 61 is mounted on the first support component 1, and the fourth fixing block 62 is mounted on the second support component 2. The first group of limiting slots 611 may be provided on the third fixing block 61. The second group of limiting slots 621 may be provided on the second support component 2.

There are two third fixing blocks 61, respectively disposed on two opposite sides of the first sliding portion 632, and configured to prevent the first group of limiting rods 635 from falling off the first group of limiting slots 611.

There are two fourth fixing blocks 62, respectively disposed on two opposite sides of the second sliding portion 634, and configured to prevent the second group of limiting rods 636 from falling off the second group of limiting slots 621.

As shown in FIG. 12, the limiting hinge 63 includes a plurality of limiting chain segments 631, and the adjacent limiting chain segments 631 are connected by tooth meshing. Each limiting chain segment 631 includes two central shafts. The first group of limiting rods 635 includes a first rod 6351 and a second rod 6352. A central line of the first rod 6351 and a central line of the second rod 6352 are respectively connected to and collinear in the two central shafts of the limiting chain segment 631. The first group of limiting slots 611 includes a first slot 6111 and a second slot 6112. Extension directions of the first slot 6111 and the second slot 6112 are different, so that a moving track of the limiting hinge 63 in the folding or unfolding process of the foldable component 10 is determined. The first rod 6351 cooperates with the first slot 6111, and the second rod 6352 cooperates with the second slot 6112, so that the limiting chain segments 631 can move and rotate simultaneously.

An extension direction of the first slot 6111 or the second slot 6112 is parallel to a surface of the first support component 1 connected to the support layer 4, so that a travel range of the limiting chain segments 631 is shortened. As shown in FIG. 12, the extension direction of the second slot 6112 is parallel to the surface of the first support component 1 connected to the support layer 4.

In an optional embodiment, the support layer 4 is fixedly connected to the first support component 1 and the second support component 2. The support layer 4 is in contact with and connected to the bending support component 3. For example, the support layer 4 is fixedly fitted onto the first support component 1 and the second support component 2. The support layer 4 may be detachably connected to the bending support component 3.

As shown in FIG. 1, FIG. 2, FIG. 10, and FIG. 11, the flexible display panel 20 forms a first display area 201, a second display area 202, and a third display area 203 that are connected in sequence. The first display area 201 faces the first support component 1. The second display area 202 faces the bending support component 3. The third display area 203 faces the second support component 2.

The flexible display panel 20 also has display and touch functions. The second display area 202 may be configured to display common function applications of the mobile terminal 100, for example, weather, time, and message notifications.

The mobile terminal 100 in this application includes but is not limited to a mobile phone, a notebook, a tablet computer, a POS machine, an in-vehicle computer, a camera, or the like.

The embodiments of this application are described in detail above. The principle and implementation of this application are described herein through specific examples. The description about the embodiments of this application is merely provided to help understand the method and core ideas of this application. In addition, a person of ordinary skill in the art can make variations and modifications to this application in terms of the specific implementations and application scopes according to the ideas of this application. Therefore, the content of specification shall not be construed as a limit to this application.

## Claims

1. A foldable component (10) for a mobile terminal, comprising:
a first support component (1), providing a first sliding slot (11);
a second support component (2), providing a second sliding slot (21);
a bending support component (3), connected between the first support component (1) and the second support component (2), wherein the bending support component (3) comprises a first end (31) and a second end (32) that are opposite to each other, the first end (31) extends into the first sliding slot (11), and the second end (32) extends into the second sliding slot (21); and
a support layer (4), configured to bear a flexible display panel (20), wherein the support layer (4) is attached to the first support component (1), the bending support component (3), and the second support component (2), the bending support component (3) is configured to allow the first end (31) to slide in the first sliding slot (11) and the second end (32) to slide in the second sliding slot (21) in a folding or unfolding process of the bending support component (3), the first support component (1), the bending support component (3), and the second support component (2) are configured to drive folding or unfolding of the support layer (4), such that no relative offset exists between the first support component (1) and the support layer (4), no relative offset exists between the second support component (2) and the support layer (4), and no relative offset exists between the support layer (4) and a fitting surface between the bending support component (3) and the support layer (4);
wherein the bending support component (3) comprises a first sliding block (33), a hinge (34), and a second sliding block (35) that are connected in sequence, the first sliding block (33) is configured to cooperate with the first sliding slot (11), the second sliding block (35) is configured to cooperate with the second sliding slot (21), the first end (31) is formed at an end of the first sliding block (33) far away from the hinge (34), and the second end (32) is formed at an end of the second sliding block (35) far away from the hinge (34);
wherein the hinge (34) comprises a first chain segment (341), at least one intermediate chain segment (342), and a second chain segment (343) that are connected in sequence by means of tooth meshing, a fixed connection exists between the first chain segment (341) and the first sliding block (33), and a fixed connection exists between the second chain segment (343) and the second sliding block (35);
**characterized in that** the foldable component (10) further comprises a limiting block (53), the limiting block (53) is located between the first support component (1) and the second support component (2), the at least one intermediate chain segment (342) is rotationally connected to the limiting block (53), and the limiting block (53) comprises a first limiting rod (531) and a second limiting rod (532) that are disposed opposite to each other; and
a first limiting slot (511) is provided on the first support component (1), a second limiting slot (521) is provided on the second support component (2), the first limiting rod (531) is configured to cooperate with the first limiting slot (511), the second limiting rod (532) is configured to cooperate with the second limiting slot (521), and in a process in which the first support component (1) is folded or unfolded relative to the second support component (2), the first support component (1) is configured to move relative to the first limiting rod (531) along an extension track of the first limiting slot (511), and the second support component (2) is configured to move relative to the second limiting rod (532) along an extension track of the second limiting slot (521).

2. The foldable component (10) according to claim 1, wherein after the hinge (34) is folded, an arc external profile is formed, and the arc external profile is configured to to support the support layer (4).

3. The foldable component (10) according to claim 1, wherein sidewalls of the first limiting slot (511) and the second limiting slot (521) both have an arc surface.

4. The foldable component (10) according to claim 1, wherein the foldable component (10) further comprises a first fixing block (51) and a second fixing block (52), the first fixing block (51) is mounted on the first support component (1), the second fixing block (52) is mounted on the second support component (2), a third sliding slot (512) is provided on one side of the first fixing block (51), and a fourth sliding slot (522) is provided on one side of the second fixing block (52); and
the foldable component (10) further comprises a third sliding block (54), a second hinge (55), and a fourth sliding block (56) that are connected in sequence, the third sliding block (54) extends into the third sliding slot (512), a moving direction of the third sliding block (54) in the third sliding slot is consistent with a moving direction of the first sliding block (33) in the first sliding slot (11), the fourth sliding block (56) extends into the fourth sliding slot (522), a moving direction of the fourth sliding block (56) in the fourth sliding slot (522) is consistent with a moving direction of the second sliding block (35) in the second sliding slot (21), the second hinge (55) is disposed side by side with the hinge (34) to jointly support the support layer (4) and is configured to keep a same moving track as the hinge (34), and the limiting block (53) is mounted on the second hinge (55) and configured to limit a moving position of the second hinge (55).

5. The foldable component (10) according to claim 4, wherein the second hinge (55) is connected to one end of the hinge (34) and is configured to rotate synchronously with the hinge (34).

6. The foldable component (10) according to claim 1, wherein after the hinge (34) is folded, an arc internal profile is formed, and the arc internal profile is configured to to support the support layer (4).

7. The foldable component (10) according to claim 6, wherein the support layer (4) is a continuous elastic metal sheet.

8. The foldable component (10) according to claim 6, wherein the foldable component (10) further comprises a limiting hinge (63), the limiting hinge (63) forms a first sliding portion (632), a connecting portion (633), and a second sliding portion (634) that are connected in sequence, the hinge (34) of the bending support component (3) is rotationally connected to the connecting portion (633), the first sliding portion (632) comprises a first group of limiting rods (635), and the second sliding portion (634) comprises a second group of limiting rods (636); and
a first group of limiting slots (611) is provided on the first support component (1), a second group of limiting slots (621) is provided on the second support component (2), the first group of limiting rods (635) is configured to cooperate with the first group of limiting slots (611), the second group of limiting rods (636) is configured to cooperate with the second group of limiting slots (621), and the limiting hinge (63) is configured to limit a moving position of the hinge (34).

9. The foldable component (10) according to claim 8, wherein the limiting hinge (63) comprises a plurality of limiting chain segments (631), the adjacent limiting chain segments (631) are connected by means of tooth meshing, each limiting chain segment (631) comprises two central shafts, the first group of limiting rods (635) comprises a first rod (6351) and a second rod (6352), a central line of the first rod (6351) and a central line of the second rod (6352) are respectively connected to and collinear in the two central shafts, the first group of limiting slots (611) comprises a first slot (6111) and a second slot (6112), extension directions of the first slot (6111) and the second slot (6112) are different, so that a moving track of the limiting hinge (63) in a folding or unfolding process of the foldable component (10) is determined, the first rod (6351) is configured to cooperate with the first slot (6111), and the second rod (6352) is configured to cooperate with the second slot (6112).

10. The foldable component (10) according to claim 9, wherein an extension direction of the first slot (6111) or the second slot (6112) is parallel to a surface of the first support component (1) connected to the support layer (4).

11. A mobile terminal (100), comprising the foldable component (10) according to any one of claims 1 to 10 and a flexible display panel (20), wherein the flexible display panel (20) is attached to the support layer (4), the flexible display panel (20) forms a first display area (201), a second display area (202), and a third display area (203) that are connected in sequence, the first display area (201) faces the first support component (1), the second display area (202) faces the bending support component (3), and the third display area (203) faces the second support component (2).

## Patentansprüche

1. Klappbares Bauteil (10) für ein mobiles Endgerät, umfassend:
ein erstes Stützbauteil (1), das einen ersten Gleitspalt (11) bereitstellt;
ein zweites Stützbauteil (2), das einen zweiten Gleitspalt (21) bereitstellt;
ein Biegestützbauteil (3), verbunden zwischen dem ersten Stützbauteil (1) und dem zweiten Stützbauteil (2), wobei das Biegestützbauteil (3) ein erstes Ende (31) und ein zweites Ende (32) umfasst, die einander gegenüberliegen, wobei sich das erste Ende (31) in den ersten Gleitspalt (11) erstreckt und sich das zweite Ende (32) in den zweiten Gleitspalt (21) erstreckt; und
eine Stützschicht (4), dazu ausgelegt, eine flexible Displaytafel (20) zu tragen, wobei die Stützschicht (4) an dem ersten Stützbauteil (1), dem Biegestützbauteil (3) und dem zweiten Stützbauteil (2) angebracht ist, wobei das Biegestützbauteil (3) dazu ausgelegt ist, in einem Faltungs- oder Entfaltungsprozess des Biegestützbauteils (3) dem ersten Ende (31) zu gestatten, in den ersten Gleitspalt (11) zu gleiten, und dem zweiten Ende (32), in den zweiten Gleitspalt (21) zu gleiten, wobei das erste Stützbauteil (1), das Biegestützbauteil (3) und das zweite Stützbauteil (2) dazu ausgelegt sind, ein Falten oder Entfalten der Stützschicht (4) anzutreiben, sodass zwischen dem ersten Stützbauteil (1) und der Stützschicht (4) kein relativer Versatz existiert, zwischen dem zweiten Stützbauteil (2) und der Stützschicht (4) kein relativer Versatz existiert, und zwischen der Stützschicht (4) und einer Montageoberfläche zwischen dem Biegestützbauteil (3) und der Stützschicht (4) kein relativer Versatz existiert;
wobei das Biegestützbauteil (3) einen ersten Gleitblock (33), ein Scharnier (34) und einen zweiten Gleitblock (35) umfasst, die aufeinanderfolgend verbunden sind,
wobei der erste Gleitblock (33) dazu ausgelegt ist, mit dem ersten Gleitspalt (11) zusammenzuwirken, der zweite Gleitblock (35) dazu ausgelegt ist, mit dem zweiten Gleitspalt (21) zusammenzuwirken, das erste Ende (31) an einem Ende des ersten Gleitblocks (33), von dem Scharnier (34) weit entfernt, ausgebildet ist, und das zweite Ende (32) an einem Ende des zweiten Gleitblocks (35), von dem Scharnier (34) weit entfernt, ausgebildet ist;
wobei das Scharnier (34) ein erstes Kettensegment (341), mindestens ein Kettenzwischensegment (342) und ein zweites Kettensegment (343) umfasst, die aufeinanderfolgend mittels Zahneingriff verbunden sind, wobei zwischen dem ersten Kettensegment (341) und dem ersten Gleitblock (33) eine feste Verbindung existiert, und zwischen dem zweiten Kettensegment (343) und dem zweiten Gleitblock (35) eine feste Verbindung existiert;
**dadurch gekennzeichnet, dass** das klappbare Bauteil (10) ferner einen Begrenzungsblock (53) umfasst, wobei der Begrenzungsblock (53) zwischen dem ersten Stützbauteil (1) und dem zweiten Stützbauteil (2) positioniert ist, das mindestens eine Kettenzwischensegment (342) drehbar mit dem Begrenzungsblock (53) verbunden ist, und der Begrenzungsblock (53) einen ersten Begrenzungsstab (531) und einen zweiten Begrenzungsstab (532) umfasst, die einander gegenüber angeordnet sind; und
ein erster Begrenzungsspalt (511) an dem ersten Stützbauteil (1) vorgesehen ist, ein zweiter Begrenzungsspalt (521) an dem zweiten Stützbauteil (2) vorgesehen ist, der erste Begrenzungsstab (531) dazu ausgelegt ist, mit dem ersten Begrenzungsspalt (511) zusammenzuwirken, der zweite Begrenzungsstab (532) dazu ausgelegt ist, mit dem zweiten Begrenzungsspalt (521) zusammenzuwirken, und in einem Prozess, in dem das erste Stützbauteil (1) relativ zu dem zweiten Stützbauteil (2) eingeklappt oder ausgeklappt wird, das erste Stützbauteil (1) dazu ausgelegt ist, sich relativ zu dem ersten Begrenzungsstab (531) entlang einer Verlängerungsspur des ersten Begrenzungsspalts (511) zu bewegen, und das zweite Stützbauteil (2) dazu ausgelegt ist, sich relativ zu dem zweiten Begrenzungsstab (532) entlang einer Verlängerungsspur des zweiten Begrenzungsspalts (521) zu bewegen.

2. Klappbares Bauteil (10) nach Anspruch 1, wobei nach dem Einklappen des Scharniers (34) ein bogenförmiges äußeres Profil ausgebildet wird, und das bogenförmige äußere Profil dazu ausgelegt ist, die Stützschicht (4) zu stützen.

3. Klappbares Bauteil (10) nach Anspruch 1, wobei Seitenwände des ersten Begrenzungsspalts (511) und des zweiten Begrenzungsspalts (521) beide eine bogenförmige Oberfläche aufweisen.

4. Klappbares Bauteil (10) nach Anspruch 1, wobei das klappbare Bauteil (10) ferner einen ersten Befestigungsblock (51) und einen zweiten Befestigungsblock (52) umfasst, wobei der erste Befestigungsblock (51) an dem ersten Stützbauteil (1) montiert ist, der zweite Befestigungsblock (52) an dem zweiten Stützbauteil (2) montiert ist, ein dritter Gleitspalt (512) auf einer Seite des ersten Befestigungsblocks (51) vorgesehen ist, und ein vierter Gleitspalt (522) auf einer Seite des zweiten Befestigungsblocks (52) vorgesehen ist; und
das klappbare Bauteil (10) ferner einen dritten Gleitblock (54), ein zweites Scharnier (55) und einen vierten Gleitblock (56) umfasst, die aufeinanderfolgend verbunden sind, wobei sich der dritte Gleitblock (54) in den dritten Gleitspalt (512) erstreckt, eine Bewegungsrichtung des dritten Gleitblocks (54) in dem dritten Gleitspalt konsistent mit einer Bewegungsrichtung des ersten Gleitblocks (33) in dem ersten Gleitspalt (11) ist, sich der vierte Gleitblock (56) in den vierten Gleitspalt (522) erstreckt, eine Bewegungsrichtung des vierten Gleitblocks (56) in dem vierten Gleitspalt (522) konsistent mit einer Bewegungsrichtung des zweiten Gleitblocks (35) in dem zweiten Gleitspalt (21) ist, das zweite Scharnier (55) neben dem Scharnier (34) angeordnet ist, damit diese gemeinsam die Stützschicht (4) stützen, und dazu ausgelegt ist, eine gleiche Bewegungsspur wie das Scharnier (34) zu halten, und der Begrenzungsblock (53) an dem zweiten Scharnier (55) montiert und dazu ausgelegt ist, eine Bewegungsposition des zweiten Scharniers (55) zu begrenzen.

5. Klappbares Bauteil (10) nach Anspruch 4, wobei das zweite Scharnier (55) mit einem Ende des Scharniers (34) verbunden ist und dazu ausgelegt ist, sich synchron mit dem Scharnier (34) zu drehen.

6. Klappbares Bauteil (10) nach Anspruch 1, wobei nach dem Einklappen des Scharniers (34) ein bogenförmiges internes Profil ausgebildet wird, und das bogenförmige interne Profil dazu ausgelegt ist, die Stützschicht (4) zu stützen.

7. Klappbares Bauteil (10) nach Anspruch 6, wobei die Stützschicht (4) ein kontinuierliches elastisches Metallblech ist.

8. Klappbares Bauteil (10) nach Anspruch 6, wobei das klappbare Bauteil (10) ferner ein Begrenzungsscharnier (63) umfasst, wobei das Begrenzungsscharnier (63) einen ersten Gleitabschnitt (632), einen Verbindungsabschnitt (633) und einen zweiten Gleitabschnitt (634) ausbildet, die aufeinanderfolgend verbunden sind, wobei das Scharnier (34) des Biegestützbauteils (3) drehbar mit dem Verbindungsabschnitt (633) verbunden ist, der erste Gleitabschnitt (632) eine erste Gruppe von Begrenzungsstäben (635) umfasst, und der zweite Gleitabschnitt (634) eine zweite Gruppe von Begrenzungsstäben (636) umfasst; und
eine erste Gruppe von Begrenzungsspalten (611) an dem ersten Stützbauteil (1) vorgesehen ist, eine zweite Gruppe von Begrenzungsspalten (621) an dem zweiten Stützbauteil (2) vorgesehen ist, die erste Gruppe von Begrenzungsstäben (635) dazu ausgelegt ist, mit der ersten Gruppe von Begrenzungsspalten (611) zusammenzuwirken, die zweite Gruppe von Begrenzungsstäben (636) dazu ausgelegt ist, mit der zweiten Gruppe von Begrenzungsspalten (621) zusammenzuwirken, und das Begrenzungsscharnier (63) dazu ausgelegt ist, eine Bewegungsposition des Scharniers (34) zu begrenzen.

9. Klappbares Bauteil (10) nach Anspruch 8, wobei das Begrenzungsscharnier (63) eine Vielzahl von begrenzenden Kettensegmenten (631) umfasst, wobei die benachbarten begrenzenden Kettensegmente (631) mittels Zahneingriff verbunden sind, wobei jedes begrenzende Kettensegment (631) zwei zentrale Wellen umfasst, die erste Gruppe von Begrenzungsstäben (635) einen ersten Stab (6351) und einen zweiten Stab (6352) umfasst, eine Mittellinie des ersten Stabes (6351) und eine Mittellinie des zweiten Stabes (6352) mit den zwei zentralen Wellen verbunden sind und kollinear in ihnen verlaufen, die erste Gruppe von Begrenzungsstäben (611) einen ersten Spalt (6111) und einen zweiten Spalt (6112) umfasst, sich Verlängerungsrichtungen des ersten Spalts (6111) und des zweiten Spalts (6112) unterscheiden, sodass eine Bewegungsspur des Begrenzungsscharniers (63) in einem Einklapp- oder Ausklappprozess des klappbaren Bauteils (10) bestimmt ist, der erste Stab (6351) dazu ausgelegt ist, mit dem ersten Spalt (6111) zusammenzuwirken, und der zweite Stab (6352) dazu ausgelegt ist, mit dem zweiten Spalt (6112) zusammenzuwirken.

10. Klappbares Bauteil (10) nach Anspruch 9, wobei eine Verlängerungsrichtung des ersten Spalts (6111) oder des zweiten Spalts (6112) parallel zu einer Oberfläche des ersten Stützbauteils (1) verläuft, das mit der Stützschicht (4) verbunden ist.

11. Mobiles Endgerät (100), umfassend das klappbare Bauteil (10) nach einem der Ansprüche 1 bis 10 und eine flexible Displaytafel (20), wobei die flexible Displaytafel (20) an der Stützschicht (4) angebracht ist, die flexible Displaytafel (20) eine erste Displayfläche (201), eine zweite Displayfläche (202) und eine dritte Displayfläche (203) ausbildet, die aufeinanderfolgend verbunden sind, die erste Displayfläche (201) dem ersten Stützbauteil (1) zugewandt ist, die zweite Displayfläche (202) dem Biegestützbauteil (3) zugewandt ist, und die dritte Displayfläche (203) dem zweiten Stützbauteil (2) zugewandt ist.

## Revendications

1. Élément pliable (10) pour un terminal mobile, comprenant :
un premier composant de support (1), qui présente une première fente de coulissement (11) ;
un deuxième composant de support (2), qui présente une deuxième fente de coulissement (21) ;
un composant de support courbé (3), relié entre le premier composant de support (1) et le deuxième composant de support (2), dans lequel le composant de support courbé (3) comprend une première extrémité (31) et une deuxième extrémité (32) qui sont opposées l'une à l'autre, la première extrémité (31) s'étend dans la première fente de coulissement (11), et la deuxième extrémité (32) s'étend dans la deuxième fente de coulissement (21) ;
et
une couche de support (4), configurée pour supporter un panneau d'affichage souple (20), la couche de support (4) étant fixée au premier composant de support (1), au composant de support courbé (3) et au deuxième composant de support (2), le composant de support courbé (3) est configuré pour permettre à la première extrémité (31) de glisser dans la première fente de coulissement (11) et à la deuxième extrémité (32) de glisser dans la deuxième fente de coulissement (21), dans un processus de pliage ou de dépliage du composant de support courbé (3), le premier composant de support (1), le composant de support courbé (3) et le deuxième composant de support (2) sont configurés pour entraîner le pliage ou le dépliage de la couche de support (4), de sorte qu'aucun décalage relatif n'est présent entre le premier composant de support (1) et la couche de support (4), qu'aucun décalage relatif n'est présent entre le second composant de support (2) et la couche de support (4), et qu'aucun décalage relatif n'est présent entre la couche de support (4) et une surface de fixation entre le composant de support courbé (3) et la couche de support (4) ;
le composant de support courbé (3) comprenant un premier bloc de coulissement (33), une charnière (34) et un deuxième bloc de coulissement (35) qui sont connectés en séquence, le premier bloc de coulissement (33) est configuré pour coopérer avec la première fente de coulissement (11), le deuxième bloc de coulissement (35) est configuré pour coopérer avec la deuxième fente de coulissement (21), la première extrémité (31) est formée à une extrémité du premier bloc de coulissement (33) éloignée de la charnière (34), et la deuxième extrémité (32) est formée à une extrémité du deuxième bloc de coulissement (35) éloignée de la charnière (34) ;
la charnière (34) comprenant un premier segment de chaîne (341), au moins un segment de chaîne intermédiaire (342) et un deuxième segment de chaîne (343) qui sont connectés en séquence au moyen d'un engrènement de dents, une liaison fixe existe entre le premier segment de chaîne (341) et le premier bloc de coulissement (33) et une liaison fixe existe entre le deuxième segment de chaîne (343) et le deuxième bloc de coulissement (35) ;
**caractérisé en ce que** l'élément pliable (10) comprend en outre un bloc de limitation (53), le bloc de limitation (53) est situé entre le premier composant de support (1) et le deuxième composant de support (2), l'au moins un segment de chaîne intermédiaire (342) est connecté en rotation au bloc de limitation (53), et le bloc de limitation (53) comprend une première tige de limitation (531) et une deuxième tige de limitation (532) qui sont disposées opposées l'une à l'autre, et
une première fente de limitation (511) est prévue sur le premier composant de support (1), une deuxième fente de limitation (521) est prévue sur le deuxième composant de support (2), la première tige de limitation (531) est configurée pour coopérer avec la première fente de limitation (511), la deuxième tige de limitation (532) est configurée pour coopérer avec la
deuxième fente de limitation (521), et dans un procédé dans lequel le premier composant de support (1) est plié ou déplié par rapport au deuxième composant de support (2), le premier composant de support (1) est configuré pour se déplacer par rapport à la première tige de limitation (531) le long d'une piste d'extension de la première fente de limitation (511), et le deuxième composant de support (2) est configuré pour se déplacer par rapport à la deuxième tige de limitation (532) le long d'une piste d'extension de la deuxième fente de limitation (521).

2. Élément pliable (10) selon la revendication 1, dans lequel, après le pliage de la charnière (34), un profil extérieur en arc est formé, et le profil extérieur en arc est configuré pour supporter la couche de support (4).

3. Élément pliable (10) selon la revendication 1, dans lequel les parois latérales de la première fente de limitation (511) et de la deuxième fente de limitation (521) présentent toutes deux une surface en arc.

4. Élément pliable (10) selon la revendication 1, dans lequel l'élément pliable (10) comprend en outre un premier bloc de fixation (51) et un deuxième bloc de fixation (52), le premier bloc de fixation (51) est monté sur le premier composant de support (1), le deuxième bloc de fixation (52) est monté sur le deuxième composant de support (2), une troisième fente de coulissement (512) est prévue sur un côté du premier bloc de fixation (51) et une quatrième fente de coulissement (522) est prévue sur un côté du deuxième bloc de fixation (52) ; et
l'élément pliable (10) comprend en outre un troisième bloc de coulissement (54), une deuxième charnière (55) et un quatrième bloc de coulissement (56) qui sont connectés en séquence, le troisième bloc de coulissement (54) s'étend dans la troisième fente de coulissement (512), une direction de déplacement du troisième bloc de coulissement (54) dans la troisième fente de coulissement est cohérente avec une direction de déplacement du premier bloc de coulissement (33) dans la première fente de coulissement (11), le quatrième bloc de coulissement (56) s'étend dans la quatrième fente de coulissement (522), une direction de déplacement du quatrième bloc de coulissement (56) dans la quatrième fente de coulissement (522) est cohérente avec une direction de déplacement du deuxième bloc de coulissement (35) dans la deuxième fente de coulissement (21), la deuxième charnière (55) est disposée côte à côte avec la charnière (34) pour supporter conjointement la couche de support (4) et est configurée pour maintenir une même piste mobile que la charnière (34), et le bloc de limitation (53) est monté sur la deuxième charnière (55) et configuré pour limiter une position mobile de la deuxième charnière (55).

5. Élément pliable (10) selon la revendication 4, dans lequel la deuxième charnière (55) est reliée à une extrémité de la charnière (34) et est configurée pour tourner de façon synchrone avec la charnière (34).

6. Élément pliable (10) selon la revendication 1, dans lequel, après le pliage de la charnière (34), un profil intérieur en arc est formé et le profil intérieur en arc est configuré pour supporter la couche de support (4).

7. Élément pliable (10) selon la revendication 6, dans lequel la couche de support (4) est une tôle métallique élastique continue.

8. Élément pliable (10) selon la revendication 6, dans lequel l'élément pliable (10) comprend en outre une charnière de limitation (63), la charnière de limitation (63) forme une première partie de coulissement (632), une partie de liaison (633) et une deuxième partie de coulissement (634) qui sont connectées en séquence, la charnière (34) du composant de support courbé (3) est connectée en rotation à la partie de liaison (633), la première partie de coulissement (632) comprend un premier groupe de tiges de limitation (635), et la deuxième partie de coulissement (634) comprend un deuxième groupe de tiges de limitation (636) ; et
un premier groupe de fentes de limitation (611) est prévu sur le premier composant de support (1), un deuxième groupe de fentes de limitation (621) est prévu sur le deuxième composant de support (2), le premier groupe de tiges de limitation (635) est configuré pour coopérer avec le premier groupe de fentes de limitation (611), le deuxième groupe de tiges de limitation (636) est configuré pour coopérer avec le deuxième groupe de fentes de limitation (621) et la charnière de limitation (63) est configurée pour limiter une position mobile de la charnière (34).

9. Élément pliable (10) selon la revendication 8, dans lequel la charnière de limitation (63) comprend une pluralité de segments de chaîne de limitation (631), les segments de chaîne de limitation adjacents (631) sont reliés au moyen d'un engrènement de dents, chaque segment de chaîne de limitation (631) comprend deux arbres centraux, le premier groupe de tiges de limitation (635) comprend une première tige (6351) et une deuxième tige (6352), une ligne centrale de la première tige (6351) et une ligne centrale de la deuxième tige (6352) sont respectivement connectées et colinéaires dans les deux arbres centraux, le premier groupe de fentes de limitation (611) comprend une première fente (6111) et une deuxième fente (6112), les directions d'extension de la première fente (6111) et de la deuxième fente (6112) sont différentes, de sorte qu'une piste mobile de la charnière de limitation (63) est déterminée dans un processus de pliage ou de dépliage de l'élément pliable (10), la première tige (6351) est configurée pour coopérer avec la première fente (6111) et la deuxième tige (6352) est configurée pour coopérer avec la deuxième fente (6112).

10. Élément pliable (10) selon la revendication 9, dans lequel une direction d'extension de la première fente (6111) ou de la deuxième fente (6112) est parallèle à une surface du premier composant de support (1) connectée à la couche support (4).

11. Terminal mobile (100), comprenant l'élément pliable (10) selon l'une quelconque des revendications 1 à 10 et un panneau d'affichage souple (20), dans lequel le panneau d'affichage souple (20) est fixé à la couche de support (4), le panneau d'affichage souple (20) formant une première zone d'affichage (201), une deuxième zone d'affichage (202), et une troisième zone d'affichage (203) qui sont connectées en séquence, la première zone d'affichage (201) faisant face au premier composant de support (1), la deuxième zone d'affichage (202) faisant face au composant de support courbé (3), et la troisième zone d'affichage (203) faisant face au deuxième composant de support (2).
